# EUROPEAN PATENT SPECIFICATION

(11) **EP 2 625 718 B1**
(45) Date of publication and mention of the grant of the patent: **16.12.2020**
(21) Application number: 11831440.0
(22) Date of filing: 04.10.2011
(51) Int. Cl.: H01L 31/042, H01L 31/0216, G02B 1/14

(54) **METHOD OF COATING OPTICAL COMPONENTS OF SOLAR ENERGY SYSTEMS**
VERFAHREN ZUM BESCHICHTEN VON OPTISCHEN KOMPONENTEN VON SOLARENERGIEANLAGEN
MÉTHODE DE REVÊTEMENT POUR COMPOSANTS OPTIQUES DE SYSTÈMES D'ÉNERGIE SOLAIRE

(30) Priority: 06.10.2010 US 390492 P
(43) Date of publication of application: 14.08.2013
(73) Proprietor: 3M Innovative Properties Company, St. Paul, MN 55133-3427 (US)
(72) Inventor: BROWN, Katherine, A., Minnesota 55133-3427 (US); JING, Naiyong, Minnesota 55133-3427 (US); HEBRINK, Timothy, J., Minnesota 55133-3427 (US); CHEN, Daniel, T., Minnesota 55133-3427 (US)
(74) Representative: Vossius & Partner Patentanwälte Rechtsanwälte mbB
(86) International application number: PCT/US2011/054746
(87) International publication number: WO 2012/047872

(56) References cited:
- EP-A1- 0 823 405
- WO-A1-2009/140482
- WO-A1-2010/104146
- WO-A2-2008/028640
- WO-A2-2008/028640
- WO-A2-2011/062880
- US-A1- 2009 283 133
- US-A1- 2010 101 621
- CARUSO F ET AL: "Preparation and Characterization of Ordered Nanoparticle and Polymer Composite Multilayers on Colloids", LANGMUIR, AMERICAN CHEMICAL SOCIETY, US, vol. 15, 1 January 1999 (1999-01-01), pages 8276-8281, XP002476288, ISSN: 0743-7463, DOI: 10.1021/LA990426V

## Description

### TECHNICAL FIELD

The present disclosure broadly relates to solar energy systems using compositions useful for coating substrates.

### BACKGROUND

Many systems utilizing solar energy conversion systems have been developed to convert sunlight into electricity. Some of these systems, often referred to as Concentrated Photovoltaic (CPV) systems, rely on a lens or one or more mirrors that direct or concentrate sunlight onto a photovoltaic (PV) component (cell) that directly converts light into electricity. Other systems, often referred to as Concentrating Solar Power (CSP) systems, rely on the conversion of concentrated sunlight into heat, and subsequent utilization of the heat to generate electricity.

Typically, a system may be designed for use on a commercial building such as an office building or a large retail store, or as a utility-scale system. A wide variety of solar energy system designs have been developed for this diverse set of applications. In spite of the huge diversity of solar energy system designs, they all share the need to provide electricity at the lowest possible installed cost. And they all comprise at least one solar optical component, which must either direct or concentrate sunlight in a specific way.

Many solar energy systems are advantageously installed in hot, dry climates and, in particular, in deserts. However, a common problem in desert locations is accumulation of dust on the exposed surfaces of the optical components of a solar energy system, resulting in reduced optical performance. Typically, over a period of time, the electricity produced by the solar energy system decreases as dust accumulates, resulting in losses of from 5 to 40% relative to the originally installed, clean system. Thus, there is a need to provide solar optical components that will maintain optical performance in the presence of desert dust.

There have been many efforts to develop compositions that can be applied to substrates to provide a beneficial protective layer with desirable properties such as one or more of easy cleaning, stain prevention, and long lasting performance. Many compositions developed for such applications rely on materials (e.g., volatile organic solvents) that can present environmental issues and/or involve complex application processes. Further, problems relating to inadequate shelf-life continue to plague product developers of such compositions.

Accordingly, for many products a tradeoff of attributes is typically struck between the desired performance attributes, environmental friendliness of the materials, satisfactory shelf-life, and ease of use by a relatively unskilled user.

There remains a need for shelf-stable environmentally friendly compositions that can be coated on a substrate (e.g., a solar optical component) to provide long lasting protection from dust accumulation, especially if they can be readily handled by a relatively unskilled user.

### SUMMARY

The present application is directed to a method of providing a coating to a surface of an optical element of a solar energy conversion system. The method , as defined in the appended claims, comprises coating the surface of the optical element with an aqueous coating composition comprising water and silica nanoparticles dispersed in the water; and drying the coating composition to form a nanoparticle coating. The silica nanoparticles comprise a polymer core surrounded by a shell comprising nonporous silica particles disposed on the polymer core.

### DETAILED DESCRIPTION

Many systems have been developed to convert sunlight into electricity, also known as a solar energy conversion system. Some CPV systems rely on a lens or one or more mirrors that direct or concentrate sunlight onto a photovoltaic (PV) component that directly converts light into electricity. CSP systems rely on the conversion of concentrated sunlight into heat, and subsequent utilization of the heat to generate electricity. All of these systems must compete with more tradition sources of electricity (such as electricity produced at a coal-burning plant) and thus a continual and ongoing desire exists for ways to either reduce the cost and/or improve the efficiency of solar energy systems, resulting in lower costs to produce electricity with these systems.

Typically, a system may be designed for use on a commercial building such as an office building or a large retail store, or as a utility-scale system. A wide variety of solar energy system designs have been developed for this diverse set of applications. Systems have also been developed to produce both heat, for example, hot water, and electricity from a single installation.

In spite of the huge diversity of solar energy system designs, they all share the need to provide electricity at the lowest possible installed cost. All solar energy conversion systems comprise at least one solar optical component, which either directs or concentrates sunlight. Optical elements include, for example glass mirrors, polymer mirrors, optical films and lenses, including Fresnel lenses. Glass mirrors can comprise a layer of glass and a layer of metal. Polymer mirrors can comprise one or more films comprising one or more organic layers and can optionally comprise a layer of metal. For example, a mirror can comprise a film of PMMA comprising a layer of silver on one surface. For another example, a mirror can comprise an optical layer stack. In another example, an optical layer stack can be combined with a layer of metal, as described, for example, in WO 2010/078105. A specific example includes those sold under the tradename MIRO-SUN reflection products made by Alanod-Solar GmbH & Co., Germany.

Typically, a CPV solar energy conversion system will comprise a plurality mirrors or lenses that direct or concentrate sunlight onto a plurality of PV cells that are combined to form larger units. The optical elements assist by providing a means to deliver the sunlight to a smaller area photovoltaic cell. A mirror may be positioned to reflect sunlight light onto the surface of the photovoltaic cell, typically providing a means to capture sunlight over an area that is at least twice as large as the area of photovoltaic cell surface. Alternatively, linear or radial Fresnel lens may capture sunlight over an area that is much larger (for example, at least ten times larger) than the area of the PV cell and focus this light on the PV cell surface.

Another example of a solar energy conversion system is a CSP system wherein large mirrors concentrate sunlight onto a heat-transfer fluid which is used to drive a steam turbine to generate electricity. Such systems may also provide a means of thermal energy storage via storage of the hot fluid, which is advantageous because the hot fluid can be used when the sun is not impinging on the systems, for example, at night. Typical system designs include optical elements such as concave mirrors, parabolic trough mirrors and one or more flat mirrors to capture sunlight over a large area and concentrate it by at least a factor of ten onto a device that convert the sunlight into heat.

Mirrors with high specular or total hemispherical reflectance may be used in CVP and especially CSP systems. Lenses and mirrors may possess additional optical properties, for example the ability to transmit, absorb or reflect light over a certain range of wavelengths. It may be preferable to provide a solar optical component that combines several optical properties, for example a solar optical film component that reflects at least a major portion of the average light across the range of wavelengths that corresponds with the absorption bandwidth of a PV cell and does not reflect a major portion of the light that is outside the absorption bandwidth of a PV cell. Examples of suitable solar optical film components are described in US2009283133 and US2009283144.

Many solar energy installations are in locations where solar irradiance is high, due to combination of latitude and climate conditions, for example, a climate where there is generally very little cloud cover. Additionally, large commercial buildings located in hot climates generally have the greatest need for electricity during the hottest part of the day, to power air-conditioning units, and the peak hours of demand for electricity are close to the peak hours of solar irradiance. Further, for utility-scale solar energy installations, a large amount of land is needed. Thus, many solar energy systems are advantageously installed in hot, dry climates and, in particular, in deserts.

A common problem in desert locations is accumulation of dust on the exposed surfaces of the optical components of a solar energy system. Air-borne desert dust typically substantially comprises particles with diameters no larger than 100 micron, and often substantially comprises particles with diameters no larger than 50 microns. Dust typically reduces optical performance by causing incident light to scatter, rather than being concentrated or reflected by the solar optical component onto the intended solar energy conversion device. As less light is delivered to the solar energy conversion device, the electricity produced by the system decreases. Typically, over a period of time, the electricity produced by the solar energy system decreases as dust accumulates, resulting in losses of from 5 to 40% relative to the originally installed, clean system. As the designed output of the installation increases, losses due to dust are increasingly unacceptable. For the largest installations, operators may be forced to clean their optical surfaces, often by methods that require the use of water. Water is expensive and scarce in most desert locations. Thus, there is a need to provide solar optical components that will maintain optical performance in the presence of desert dust.

A coating may be applied to many exposed surfaces of solar optical components. In some embodiments, the coating may be applied in the field to optical elements that are installed in existing solar energy conversion systems.

One coating comprises an aqueous continuous liquid phase, and dispersed silica nanoparticles. For the purpose of the present application, a nanoparticle is a particle less than 60 nm in volume particle average diameter.

The aqueous continuous liquid phase comprises at least 5 percent by weight of water; for example, the aqueous continuous liquid phase may comprise at least 50, 60, 70, 80, or 90 percent by weight of water, or more. While the aqueous continuous liquid phase may be essentially free of (i.e., contains less than 0.1 percent by weight of based on the total weight of the aqueous continuous liquid phase) organic solvents, especially volatile organic solvents, organic solvents may optionally be included in a minor amount if desired (for example up to 20% by weight). If present, the organic solvents should generally be water-miscible, or at least water-soluble in the amounts in which they are used, although this is not a requirement. Examples of organic solvents include acetone and lower molecular weight ethers and/or alcohols such as methanol, ethanol, isopropanol, n-propanol, glycerin, ethylene glycol, triethylene glycol, propylene glycol, ethylene glycol monomethyl or monoethyl ether, diethylene or dipropylene glycol methyl or ethyl ether, ethylene or propylene glycol dimethyl ether, and triethylene or tripropylene glycol monomethyl or monoethyl ether, n-butanol, isobutanol, s-butanol, t-butanol, and methyl acetate.

The silica nano-particle is a nominally spherical particle, or an elongated particle, or a blend of nominally spherical and elongated silica nano-particles. In other embodiments the silica nano-particle is a chain of nominally spherical particles, a chain of elongated particles, or a chain of nominally spherical and elongated particles. There may also be a blend of chains and individual nano-particles.

In order to minimize haze, the silica particles have a volume average particle diameter (i.e., a D₅₀) of 60 nanometers (nm) or less. In some embodiments, the nonporous spherical silica particles have a volume average particle diameter in a range of from 1 to 60 nm, for example in a range of from 2 to 20 nm, and in specific embodiments in a range of from 2 to 10 nm. The silica particles may have any particle size distribution consistent with the above 60 nm volume average particle diameter; for example, the particle size distribution may be monomodal, bimodal or polymodal.

Nonporous spherical silica particles in aqueous media (sols) are well known in the art and are available commercially; for example, as silica sols in water or aqueous alcohol solutions under the trade designations LUDOX from E. I. du Pont de Nemours and Co., Wilmington, DE), NYACOL from Nyacol Co. of Ashland, MA, or NALCO from Nalco Chemical Co. of Naperville, IL. One useful silica sol with a volume average particle size of 5 nm, a pH of 10.5, and a nominal solids content of 15 percent by weight, is available as NALCO 2326 from Nalco Chemical Co. Other useful commercially available silica sols include those available as NALCO 1115 and NALCO 1130 from Nalco Chemical Co., as REMASOL SP30 from Remet Corp. of Utica, NY, and as LUDOX SM from E. I. du Pont de Nemours and Co.

The nonspherical colloidal silica particles may have a uniform thickness of 5 to 25 nm, a length, D₁ of 40 to 500 nm (as measured by dynamic light-scattering method) and a degree of elongation D₁/D₂ of 5 to 30, wherein D₂ means a diameter in nm calculated by the equation D₂ =2720/S and S means specific surface area in m² /g of the particle, as is disclosed in the specification of U.S. Pat. No. 5,221 ,497.

U.S. 5,221,497 discloses a method for producing acicular silica nanoparticles by adding water-soluble calcium salt, magnesium salt or mixtures thereof to an aqueous colloidal solution of active silicic acid or acidic silica sol having a mean particle diameter of 3 to 30 nm in an amount of 0.15 to 1.00 wt. % based on CaO, MgO or both to silica, then adding an alkali metal hydroxide so that the molar ratio of SiO₂ /M₂O (M: alkali metal atom) becomes 20 to 300, and heating the obtained liquid at 60 to 300°C for 0.5 to 40 hours. The colloidal silica particles obtained by this method are elongate-shaped silica particles that have elongations of a uniform thickness within the range of 5 to 40 nm extending in only one plane.

The nonspherical silica sol may also be prepared as described by Watanabe et al. in U.S. 5,597,512. Briefly stated, the method comprises: (a) mixing an aqueous solution containing a water-soluble calcium salt or magnesium salt or a mixture of said calcium salt and said magnesium salt with an aqueous colloidal liquid of an active silicic acid containing from 1 to 6% (w/w) of SiO₂ and having a pH in the range of from 2 to 5 in an amount of 1500 to 8500 ppm as a weight ratio of CaO or MgO or a mixture of CaO and MgO to SiO₂ of the active silicic acid; (b) mixing an alkali metal hydroxide or a water-soluble organic base or a water-soluble silicate of said alkali metal hydroxide or said water-soluble organic base with the aqueous solution obtained in step (a) in a molar ratio of SiO₂/M₂O of from 20 to 200, where SiO₂ represents the total silica content derived from the active silicic acid and the silica content of the silicate and M represents an alkali metal atom or organic base molecule; and (c) heating at least a part of the mixture obtained in step (b) to 60°C or higher to obtain a heel solution, and preparing a feed solution by using another part of the mixture obtained in step (b) or a mixture prepared separately in accordance with step (b), and adding said feed solution to said heel solution while vaporizing water from the mixture during the adding step until the concentration of SiO₂ is from 6 to 30% (w/w). The silica sol produced in step (c) typically has a pH of from 8.5 to 11.

Useful nonspherical silica particles may be obtained as an aqueous suspension under the trade name SNOWTEX-UP by Nissan Chemical Industries (Tokyo, Japan). The mixture consists of 20-21 % (w/w) of acicular silica, less than 0.35% (w/w) of Na₂O, and water. The particles are about 9 to 15 nanometers in diameter and have lengths of 40 to 300 nanometers. The suspension has a viscosity of <100 mPas at 25°C, a pH of about 9 to 10.5, and a specific gravity of about 1.13 at 20°C.

Other useful acicular silica particles may be obtained as an aqueous suspension under the trade name SNOWTEX-PS-S and SNOWTEX-PS-M by Nissan Chemical Industries, having a morphology of a string of pearls. The mixture consists of 20-21 % (w/w) of silica, less than 0.2% (w/w) of Na₂O, and water. The SNOWTEX-PS-M particles are about 18 to 25 nanometers in diameter and have lengths of 80 to 150 nanometers. The particle size is 80 to 150 by dynamic light scattering methods. The suspension has a viscosity of <100 mPas at 25°C, a pH of about 9 to 10.5, and a specific gravity of about 1.13 at 20°C. The SNOWTEX-PS-S has a particle diameter of 10-15 nm and a length of 80-120 nm.

Low- and non-aqueous silica sols (also called silica organosols) may also be used and are silica sol dispersions wherein the liquid phase is an organic solvent, or an aqueous organic solvent. In the practice of this invention, the silica sol is chosen so that its liquid phase is compatible with the intended coating composition, and is typically aqueous or a low-aqueous organic solvent. Ammonium stabilized acicular silica particles may generally be diluted and acidified in any order.

Non-aqueous spherical silica sols are spherical silica sol dispersions wherein the liquid phase is an organic solvent. Typically, the silica sol is chosen so that its liquid phase is compatible with the remaining components of the continuous liquid phase. Typically, sodium-stabilized nonporous spherical silica particles should first be acidified prior to dilution with an organic solvent such as ethanol, as dilution prior to acidification may yield poor or non-uniform coatings. Ammonium-stabilized silica nanoparticles may generally be diluted and acidified in any order.

The dispersed silica nano-particles are generally present on organic polymer particles having a silica particle shell thereon, wherein the silica particles have a mean particle size of 60 nm or less. Such nano-particles are described in detail in PCT Application US 2010/027452.

As used herein, the term "shell" refers to an assembly of nonporous spherical silica particles disposed on and covering (for example, densely covering) the surface of a polymer core. The nonporous spherical silica particles may optionally be covalently bonded one to another.

The polymer core may comprise any polymer, typically one that can be prepared as a latex, more typically as an alkaline pH stable latex. Exemplary polymers include acrylic polymers, styrenic polymers, vinyl acetate-ethylene copolymers, polyvinyl acetate, styrene-butadiene rubbers, polyurethanes (including urethane-acrylic polymers), polyesters, and polyamides. Preferably, the polymer is a film-forming polymer. The polymer may be thermosetting or thermoplastic. Preferably, the polymer comprises a polyurethane segment as in the case of a polyurethane or a urethane-acrylic polymer (which typically has polyurethane and polyacrylic segments). Suitable polymer latexes and methods for making them are widely known in the art, and many are commercially available.

Examples of commercially available polymer latexes include those aqueous aliphatic polyurethane and acrylic emulsions available as NEOREZ R-960, NEOREZ R-967, NEOREZ R-9036, and NEOREZ R-9699, NEOCRYL-A612, NEOCRYL-A6044 from DSM NeoResins, Inc. of Wilmington, MA; aqueous anionic polyurethane dispersions available as ESSENTIAL CC4520, ESSENTIAL CC4560, ESSENTIAL R4100, and ESSENTIAL R4188 from Essential Industries, Inc. of Merton, WI; polyester polyurethane dispersions available as SANCURE 843, SANCURE 898, and SANCURE 12929 from Lubrizol, Inc. of Cleveland, OH; an aqueous aliphatic self-crosslinking polyurethane dispersion available as TURBOSET 2025 from Lubrizol, Inc.; and an aqueous anionic, co-solvent free, aliphatic self-crosslinking polyurethane dispersion, available as BAYHYDROL PR240 from Bayer Material Science, LLC of Pittsburgh, PA.

Combinations of polymers may be included in the polymer core. For example, an individual polymer core may comprise two or more polymers. Further, the composition may contain two types of polymer cores, each comprising a different type of polymer, for example, as would be obtained by mixing an acrylic latex and a polyurethane latex. Typically, the particles in the polymer latexes are substantially spherical in shape. Typically, the polymer core comprises one or more water-insoluble polymers, although this is not a requirement.

Useful polymer particle sizes include those typical of latexes and other dispersions or emulsions. Typical polymer particle sizes are in a range of from about 0.01 micrometers to 100 micrometers, preferably in a range of from 0.01 to 0.2 micrometers, although this is not a requirement.

Core-shell particles may typically be prepared from an alkaline pH stable polymer particle dispersion and an alkaline spherical silica sol. Typically, such polymer particle dispersions become unstable upon acidification to pH values of 5 or less. Accordingly, it is unexpected that by adding the alkaline nonporous spherical silica sol to the aqueous polymer particle dispersion, with acidification, results in core-shell particles that are stable at low pH values.

To achieve shell formation the nonporous spherical silica particles should typically be smaller than the polymer core, although this is not a requirement. For example, the volume average particle diameter (D50) of the polymer particles may be on the order of at least 3 times greater than the volume average particle diameter (D50) of the spherical silica particles. More typically, the volume average particle diameter of the polymer particles should typically be on the order of at least 5 times, at least 10 times, or even at least 50 times greater than the volume average particle diameter of the spherical silica particles. For typical polymer particle sizes, a weight ratio of the nonporous spherical silica particles to the one or more polymer particles is in a range of from 30:70 to 97:3, preferably 80:20 to 95:5, and more preferably 85:15 to 95:5.

Without wishing to be bound by theory, it is believed that during gradual acidification of such a dispersion of polymer particles (for example, latex particles) and nonporous spherical silica particles in the aqueous liquid vehicle, the nonporous spherical silica particles deposit on the surface of the polymer latex particles, eventually in sufficient quantity to form a shell (typically at least a monolayer of the spherical silica particles) that serves to stabilize the dispersion and reduce or prevent agglomeration and precipitation of the polymer particles. It is further believed that upon addition of base to raise the pH that the nonporous spherical silica particles dissociate from the polymer latex particles and regenerate a mixture of the two types of particles.

In addition, to facilitate coating, coating compositions according to the present disclosure preferably have a pH of less than 5, more preferably less than 4, and more still preferably less than 3. To facilitate handling, the coating compositions preferably have a pH of at least 1, more preferably at least 2. In some embodiments, for example, those involving an acid sensitive substrate, it may be preferable to adjust the pH to a value of from about 5 to about 7.5, although this may tend to disrupt the core-shell particle structure.

The compositions may be acidified to the desired pH level with an acid having a pKₐ of less than 5, preferably less than 2.5, and more preferably less than 1. Useful acids include both organic and inorganic acids such as, for example, oxalic acid, citric acid, benzoic acid, acetic acid, methoxyacetic acid, formic acid, propionic acid, benzenesulfonic acid, H₂SO₃, H₃PO₄, HCl, HBr, HI, HBrO₃, HNO₃, HClO₄, H₂SO₄, CH₃SO₃H, CF₃SO₃H, CF₃CO₂H, and CH₃OSO₃H. Preferred acids include HCl, H₂SO₄, and H₃PO₄. Combinations of organic and inorganic acids may also be used. Using weaker acids having a pKₐ of greater than 5 may not result in a uniform coating having the desirable properties such as transmissivity, cleanability and/or durability.

Compositions according to the present disclosure may optionally include at least one surfactant. The term "surfactant" as used herein describes molecules with hydrophilic (polar) and hydrophobic (non-polar) segments on the same molecule, and which are capable of reducing the surface tension of the composition. Examples of useful surfactants include: anionic surfactants such as sodium dodecylbenzenesulfonate, dioctyl ester of sodium sulfosuccinic acid, polyethoxylated alkyl (C12) ether sulfate, ammonium salt, and salts of aliphatic hydrogen sulfates; cationic surfactants such as alkyldimethylbenzylammonium chlorides and di-tallowdimethylammonium chloride; nonionic surfactants such as block copolymers of polyethylene glycol and polypropylene glycol, polyoxyethylene (7) lauryl ether, polyoxyethylene (9) lauryl ether, and polyoxyethylene (18) lauryl ether; and amphoteric surfactants such as N-coco-aminopropionic acid. Silicone and fluorochemical surfactants such as those available under the trade designation FLUORAD from 3M Company of St. Paul, MN, may also be used. If present, the amount of surfactant typically is in an amount of less than about 0.1 percent by weight of the composition, for example between about 0.003 and 0.05 percent by weight of the composition.

The composition may also optionally contain an antimicrobial agent. Many antimicrobial agents are commercially available. Examples include those available as: Kathon CG or LX available from Rohm and Haas Co. of Philadelphia, PA; 1,3-dimethylol-5,5-dimethylhydantoin; 2-phenoxyethanol; methyl-p-hydroxybenzoate; propyl-p- hydroxybenzoate; alkyldimethylbenzylammonium chloride; and benzisothiazolinone.

Compositions according to the present disclosure may be made by any suitable mixing technique. One useful technique includes combining an alkaline polymer latex with an alkaline spherical silica sol of appropriate particle size, and then adjusting the pH to the final desired level.

In some embodiments, the compositions are free of various nonspherical silica particles, porous silica particles, and added crosslinkers (e.g., polyaziridines or orthosilicates). Accordingly, some compositions according to the present disclosure may contain less than 0.1 weight percent or less than 0.01 weight percent of nonspherical silica particles, and, if desired, they may be free of nonspherical silica particles.

The compositions are generally coated on the optical element using conventional coating techniques, such as brush, bar, roll, wipe, curtain, rotogravure, spray, or dip coating techniques. One method is to wipe the coating formulation on using a suitable woven or nonwoven cloth, sponge, or foam. Such application materials may be acid-resistant and may be hydrophilic or hydrophobic in nature, for example hydrophilic. Another method to control final thickness and resultant appearance is to apply the coating using any suitable method and, after allowing the coating composition to dwell on the optical element for a period of time, then to rinse off excess composition with a stream of water, while the substrate is still fully or substantially wetted with the composition. For example, the coating may be allowed to dwell on the optical element for a period of time during which some solvent or water evaporates but in a sufficiently small amount that the coating remains wet, for example, 3 minutes. Methods such as spraying, brushing, wiping or allowing the coating composition to dwell followed by rinsing may be used to apply the composition to the optical element when it is already installed in a solar energy conversion system. Preferably, the wet coating thickness is in the range of 0.5 to 300 micrometers, more preferably 1 to 250 micrometers. The wet coating thickness may optionally be selected to optimize AR performance for a desired range of wavelengths. The coating composition generally contains between about 0.1 and 10 weight percent solids.

The optimal average dry coating thickness is dependent upon the particular composition that is coated, but in general the average thickness of the dry composition coating thickness is between 0.002 to 5 micrometers, preferably 0.005 to 1 micrometer.

Dry coating layer thicknesses may be higher, as high as a few microns or up to as much as 100 microns thick, depending on the application, such as for more durable easy-clean surfaces. Typically, the mechanical properties may be expected to be improved when the coating thickness is increased. However, thinner coatings still provide useful resistance to dust accumulation.

After coating the surface of the substrate, the resultant article is heated and optionally subjected to a toughening process that includes heating at an elevated temperature. The elevated temperature is generally at least 300 °C, for example at least 400 °C. In some embodiments, the heating process raises the temperature to a temperature equal to at least 500°C, at least 600°C, or at least 700°C. The temperature may be selected to cause the polymer latex from the dispersion to at least partially disappear, for example by thermal degradation. Generally, the substrate is heated for a time up to 30 minutes, up to 20 minutes, up to 10 minutes, or up to 5 minutes. The substrate surface may then be cooled rapidly, or variation of heating and cooling may be used to temper the substrate. For example, the optical element can be heated at a temperature in the range of 700°C to 750°C for about 2 to 5 minutes followed by rapid cooling.

Preferably, compositions according to the present disclosure are stable when stored in the liquid form, e.g., they do not gel, opacify, form precipitated or agglomerated particulates, or otherwise deteriorate significantly.

Objects and advantages of this disclosure are further illustrated by the following non-limiting examples, but the particular materials and amounts thereof recited in these examples, as well as other conditions and details, should not be construed to unduly limit this disclosure.

### EXAMPLES

Various modifications and alterations to this invention will become apparent to those skilled in the art without departing from the scope of this invention. It should be understood that this invention is not intended to be unduly limited by the illustrative embodiments and examples set forth herein and that such examples and embodiments are presented by way of example only with the scope of the invention intended to be limited only by the claims set forth herein as follows.

These abbreviations are used in the following examples: %T=% transmission; nm=nanometers, m=meters, g = grams, min = minutes, hr = hour, mL = milliliter, hr=hour, sec=second, L = liter. All parts, percentages, or ratios specified in the examples are by weight, unless specified otherwise. If not otherwise indicated chemicals are available from Sigma-Aldrich, St.Louis, MO.

### Materials:

### Nanoparticles

Spherical silica nanoparticle dispersions used are commercially available from the Nalco Company, Naperville, IL under the trade designations "NALCO 8699" (2-4nm) "NALCO 1115 (4nm), "NALCO 2326" (5nm), "NALCO 2327" (20 nm), and "NALCO 1050" (20nm).

Nonspherical silica nanoparticle dispersion used is commercially available under the trade designation "SNOWTEX OUP" from Nissan Chemical Industries, Ltd. (Tokyo, Japan). This nonspherical nanoparticle dispersion is 15-16 wt. % of acicular silica, less than 0.03% wt% Na₂O, and water. The particles are about 9 to 15 nm in diameter and have lengths of 40 to 100 nm. The suspensions have a viscosity of <20 mPas at 25°C, a pH of about 2-4, and a specific gravity of about 1.08-1.11 at 20°C.

### Resins used for Core of Core-Shell Particles

Polyurethane resins commercially available under the trade designations "NEOREZ R-960" and "NEOREZ R9660" and acrylic resin commercially available under the trade designation "NEOCRYL A612" were obtained from DSM Neoresins Co., Waalwijk, Netherlands.

### Other Additives

Linear alpha olefin sulfonate surfactant commercially available under the trade designation "POLYSTEP A-18" was obtained from Stepan Company (Northfield, IL).

### Substrates

PMMA: PMMA (polymethymethacrylate) substrates were Acrylite ® FF (colorless), 0.318 cm thick, obtained from Evonik Cyro LLC, Parsippany NJ. These substrates were supplied with protective masking on both sides, which was removed immediately prior to coating. PMMA panels are used, for example, as the sun-facing surface of Fresnel lens panels used in CPV systems.

Solar Glass: Solar glass substrates were Starphire ® uncoated Ultra-Clear float glass, 0.318 cm thick, manufactured by PPG Industries, Inc., Pittsburgh, PA.. Glass panels are used, for example, as the sun-facing surface of Fresnel lens panels used in CPV systems.

GM1: Glass mirror substrate 1 was UltraMirror™, 0.318 cm thick, manufactured by Guardian Industries, Auburn Hills MI.

GM2: Glass mirror substrate 2 was Plain Edge Mirror, purchased as 30.4 x 30.4 cm tiles, 3 mm thick, available in Home Depot retail outlets as Aura™ Home Design Item # P1212-NT, Home Décor Innovations, Charlotte, NC.

"SMF-1100": A polymeric silvered mirror film commercially available under the trade designation "SMF-1100" from 3M Company, St. Paul, MN. For use in Test Method 0-70 Specular reflectance, the liner was removed from the back of the film and it was laminated to aliphatic polyester painted aluminum sheets, available from American Douglas Metals, Atlanta GA, before testing. SMF-1100 is supplied with a protective mask, which was removed immediately prior to coating.

Cool mirror: A cool mirror made by laminating a visible multilayer optical film and a near infrared multilayer optical film together using an optically clear adhesive commercially available under the trade designation "OPTICALLY CLEAR LAMINATING ADHESIVE PSA 8171" from 3M Company, St. Paul, MN to create a multilayer optical film reflecting light from 380-1350nm. The preparation of the individual visible and IR mirrors are described below.

Visible Mirror: A visible reflective multilayer optical film was made with first optical layers created from polyethylene terephthalate (PET) commercially available under the trade designation "EASTAPAK 7452" from Eastman Chemical of Kingsport, TN, (PET1) and second optical layers created from a copolymer of 75 weight percent methyl methacrylate and 25 weight percent ethyl acrylate (commercially available from Ineos Acrylics, Inc. of Memphis, TN under the trade designation "PERSPEX CP63" (coPMMA1). The PET1 and CoPMMA1 were coextruded through a multilayer polymer melt manifold to form a stack of 550 optical layers. The layer thickness profile (layer thickness values) of this visible light reflector was adjusted to be approximately a linear profile with the first (thinnest) optical layers adjusted to have about a ¼ wave optical thickness (index times physical thickness) for 370 nm light and progressing to the thickest layers which were adjusted to be about ¼ wave thick optical thickness for 800 nm light. Layer thickness profiles of such films were adjusted to provide for improved spectral characteristics using the axial rod apparatus taught in U. S. Pat. No. 6,783,349 (Neavin et al.) combined with layer profile information obtained with microscopic techniques.

In addition to these optical layers, non-optical protective skin layers (260 micrometers thickness each) made from a miscible blend of PVDF (polyvinyldenedifluoride, and PMMA (polymethylmethacrylate, containing 2 wt% of a UV absorber (commercially available under the trade designation "TINUVIN 1577" from Ciba Specialty Chemicals, Basel, Switzerland) were coextruded on either side of the optical stack. This multilayer coextruded melt stream was cast onto a chilled roll at 12 m per minute creating a multilayer cast web approximately 1100 micrometers (43.9 mils) thick. The multilayer cast web was then preheated for about 10 sec at 95 °C and uniaxially oriented in the machine direction at a draw ratio of 3.3:1. The multilayer cast web was then heated in a tenter oven at 95 °C for about 10 sec prior to being uniaxially oriented in the transverse direction to a draw ratio of 3.5:1. The oriented multilayer film was further heated at 225 °C for 10 sec to increase crystallinity of the PET layers. The visible light reflective multilayer optical film was measured with a spectrophotometer ("LAMBDA 950 UV/VIS/NIR SPECTROPHOTOMETER" from Perkin-Elmer, Inc. of Waltham, MA) to have an average reflectivity of 96.8 percent over a bandwidth of 380-750 nm. The "TINUVIN 1577" UVA in the non-optical skin layers absorbs light from 300 nm to 380 nm.

Near IR Mirror: A near infra-red reflective multilayer optical film was made with first optical layers as described under "Visible Mirror" except as follows. The layer thickness profile (layer thickness values) of this near infra-red reflector was adjusted to be approximately a linear profile with the first (thinnest) optical layers adjusted to have about a ¼ wave optical thickness (index times physical thickness) for 750 nm light and progressing to the thickest layers which were adjusted to be about ¼ wave thick optical thickness for 1350 nm light. As described under "Visible Mirror", in addition to these optical layers, non-optical skin layers were coextruded but for the Near IR mirror this multilayer coextruded melt stream was cast onto a chilled roll at 6 meters per minute creating a multilayer cast web approximately 1800 micrometers (73 mils) thick. The remainder of the processing steps were identical to that of the "Visible Mirror". The IR-reflective multilayer optical film had an average reflectivity of 96.1 percent over a bandwidth of 750-1350 nm.

Broadband mirror: A broadband mirror was made by vapor coating aluminum onto the cool mirror under a vacuum of less than 2 Torr.

### Preparation of Core-Shell Polyurethane/Silica and Acrylic/Silica Coating Solutions

Polyurethane "NEOREZ R-960" latex dispersions and acrylic resin "NEOCRYL A-612" latex dispersions were diluted with deionized water to 5.0 wt% and 10 wt% individually. Nalco silica nanoparticle dispersions "NALCO 8699" (2nm-4nm, 16.5%), "NALCO 2326" (5nm), "NALCO 2327" (20 nm), "NALCO 1115" (4nm, 16.5wt%), "NALCO 1050" (22nm, 50wt%) and Nissan acicular nanoparticle dispersion "SNOWTEX OUP" (15 wt%) were diluted to 5.0 wt% and 10 wt% with deionized water individually. The diluted polyurethane or acrylic dispersions were mixed with nanoparticle dispersions respectively in ratios as described in the Tables. The resulting mixed dispersions were clear and their solutions were basic with pH values of 10-11. The mixed solutions were subsequently subjected to acid titration with IN HCl, aqueous HNO₃ or other aqueous inorganic acids to the desired pH values. The mixed dispersion solutions became slightly cloudy when the solution became acidic. If "POLYSTEP A-18" was used as indicated in the tables it was added to the solutions prior to acidification.

A specific polyurethane/silica blend "PU/Si Blend" FANTASIA was made mixing 193.2 g "NALCO 2326" and 490.43 g deionized water in a plastic jar, shaking vigorously for about 10 sec at 20°C and then adding 10.24 g "NEOREZ R9660". The mixture was shaken, 2784.6 g deionized water was added and the mixture was shaken again. The pH was adjusted by adding 80 drops of 35-38% aqueous hydrochloric acid. After standing for 30 min, the pH was found to be 2.94. An additional 8 drops of hydrochloric acid was added and the solution was mixed by inverting and shaking. The pH was found to be 2.81. An additional 14 drops of hydrochloric acid was added to bring the pH to 2.62. Seven days later, the pH of the batch was again measured and was found to be 2.64.

### Test Methods:

### Meyer Bar Coating

Where indicated in the Table the substrates were coated using a #6 Meyer bar to provide a dry coating thickness of 100-2000 nm. The coated samples were heated to 80 or 120°C (as indicated in the Table) for 5 min to 10 min to affect drying. In all cases where Meyer bar coating was used the substrate was corona-treated prior to coating on a corona treater made by Electro Technic Products Inc., Chicago. Il. (Model BD-20).

### Coating Method "3 min dwell, rinse" (3MDR)

Substrates were used as supplied. Each substrate was placed on a flat surface, and the coating formulation was applied with a pipette and spread to within about 3 mm of the edge of each sample, to produce a thoroughly covered surface (about 2 gm of coating formulation for 2.99 x 6.99 cm substrates, and about 5 gm of coating formulation for 10.16 x 15.24 cm substrates). The formulation was allowed to remain in place for 3 minutes, and then each sample was rinsed under a gentle stream of deionized water. The samples were then allowed to air dry for at least 48 hours.

### Coating Method "1 min dwell, rinse" (1MDR)

This coating method was the same as "3 Min dwell, rinse" except that the coating formulation was only in contact with the sample for 1 minute before being rinsed off with deionized water.

### Dust Treatment and "0-70 Gloss" Measurements for Transparent Substrates

Samples of solar glass were cut into pieces 6.99 x 6.99 cm and were prepared by covering the tin side with black tape (200-38 Yamato Black Vinyl Tape, Yamato International Corp., Woodhaven MI). The black tape was carefully applied by rolling the tape onto the glass, so that there were no visible bubbles or imperfections. There was one seam where parallel pieces of tape met, and care was taken to avoid this seam when taking gloss measurements later. The tape provideds a matte black surface for the gloss measurements, and also maskeds this side of the sample from dust. Subsequently, the other, untinned side of the solar glass sample was coated. Three replicates were made for each coating formulation.

Samples of PMMA substrate were supplied with a polymer film mask on both sides. We prepared sample for this test first marking one mask, so that we were always able to coat the same side of the PMMA. Then the PMMA (with mask on both sides) was cut into pieces 6.99 x 6.99 cm. The marked mask was removed, and black tape was applied in the same manner as for solar glass, above. Then the unmarked mask was removed from the other side of the sample, and the coating was applied. Three replicates were made for each coating formulation.

Subsequent to these procedures preparation of samples for solar glass and PMMA, the test method was identical.

After drying (as specified by the coating method), gloss measurements were made on at three angles and at three locations on each of the three replicates, for a total of nine measurements at each angle. Gloss measurements were made with a Model Micro-TRI-gloss gloss meter, available from BYK-Gardner USA, Columbia MD. The nine measurements at each angle were averaged, and the average and standard deviation is reported in the examples.

The samples were then placed, coated side up, in a plastic container. The container was just slightly larger than the sample (about 6 - 12 mm on each side). A portion of Arizona Test Dust, Nominal Size 0-70 micron (available from Powder Technology, Inc., Burnsville MN), approximately 3 gram, was placed on top of the sample, and a lid was placed on the container. The sample was gently shaken horizontally from one side to another, for one minute, with the Arizona test dust moving across the surface of the sample. Fresh dust was used for each sample piece. After shaking, the sample was removed from the container, placed in a vertical position, gently tapped once onto a surface, then turned 90 degrees and tapped again, and turned and tapped two more times. Gloss measurements were made again, at three angles in three locations on each of the 3 replicate samples for each formulation. The nine measurements at each angle were averaged, and the average and standard deviation is reported in the examples.

### Dust Treatment and "0-70 Specular Reflectance" for Reflective Substrates

Samples of glass mirror (GM1 or GM2, as indicated in the examples) or polymeric mirror SMF 1100 (laminated to aluminum), were cut into pieces 10.16 x 15.24 cm. The sample was then coated according to the coating methods described. Three replicates were made for each coating formulation. After drying (as specified by the coating method), specular reflectance measurements were made at three locations on each of the three replicates, for a total of nine measurements for each formulation. Specular reflectance was measured with a 15 milliradian aperture using a Portable Specular Reflectometer Model 15 R (available from Devices & Services Company, Dallas TX). The nine measurements were averaged, and the average and standard deviation is reported in the examples. The samples were then placed, coated side up, in a plastic container. The container was just slightly larger than the sample (about 6 - 12 mm on each side). A portion of Arizona Test Dust, Nominal Size 0-70 micron (available from Powder Technology, Inc., Burnsville MN), approximately 10 gram, was placed on top of the sample, and a lid was placed on the container. The sample was gently shaken horizontally from one side to another, for one minute, with the Arizona test dust moving across the surface of the sample. Fresh dust was used for each sample piece. After shaking, the sample was removed from the container, placed in a vertical position, gently tapped once onto a surface, then turned 90 degrees and tapped again, and turned and tapped two more times. Specular reflectance measurement were made again, in three locations on each of the 3 replicate samples for each formulation. The nine measurements were averaged, and the average and standard deviation is reported in the examples.

### Dust Treatment and Wavelength Averaged Reflection Measurement

A "LAMBDA 900 UV/VIS/NIR SPECTROPHOTOMETER" from Perkin-Elmer, Inc. of Waltham, MA was used to provide reflection measurements every 5 nm over the wavelength range indicated in the examples.. Results were presented as corrected average reflectivity from 400nm to 1200 nm for KFLEX, Cool Mirror and OLF 2301 and 350-2500 nm for "SMF1100" before and after dirt testing.

Coated samples , about 5.1 x 5.1 cm, were were placed, coated side up, in a plastic container. The container was just slightly larger than the sample (about 6 - 12 mm on each side). A portion of Arizona Test Dust, Nominal Size 0-600 micron (available from Powder Technology, Inc., Burnsville MN), approximately 18 gram, was placed on top of the sample, and a lid was placed on the container. The sample was gently shaken horizontally from one side to another, for one minute, with the Arizona test dust moving across the surface of the sample. Fresh dust was used for each sample piece. After shaking, the sample was removed from the container, placed in a vertical position, gently tapped once onto a surface, then turned 90 degrees and tapped again, and turned and tapped two more times.

**Table 1**

| Example | Substrate (coat method) | Composition | Solution conc wt% | pH | "0-70 Gloss" (avg/SD/angle) Before soiling | "0-70 Gloss" (avg/SD/angle) After soiling | "0-70 Specular Refl" (avg/SD) Before soiling | "0-70 Specular Refl" (avg/SD) After soiling |
|---|---|---|---|---|---|---|---|---|
| NC | PMMA | N/A | N/A | N/A | 80.4/0.1/20 85.9/0.2/60 90.0/0.3/85 | 12.7/0.2/20 3.8/0.9/60 0.6/0.1/85 | | |
| NC | Solar Glass | N/A | N/A | N/A | 84.2/0.3/20 89.4/0.2/60 90.0/0.3/85 | 70.6/1.6/20 64.4/1.4/60 30.4/3.5/85 | | |
| NC | GM1 | | | | | | 88.4/0.04 | 74.6/0.1 |
| NC | GM2 | N/A | N/A | N/A | | | 80.8/0.1 | 73.9/0.6 |
| NC | "SMF1100" | N/A | N/A | N/A | | | 95.5/0.1 | 5.8/0.2 |
| 1 | PMMA 3MDR | 9:1 "NALCO 1050": "NEOREZ R960" | 5 | 2.5 | 76.9/1.4/20 84.2/0.8/60 95.5/0.2/85 | 19.5/3.2/20 7.2/2.0/60 0.8/0.4/85 | NA | NA |
| 2 | "SMF1100" 3MDR | 9:1 "NALCO 1050": "NEOREZ R960" | 5 | 2.5 | NA | NA | 94.6/0.1 | 65.3/0.4 |
| 3 | "SMF1100" 3MDR | 9:1 "NALCO 8699": "NEOREZ R960" | 5 | 2.5 | NA | NA | 95.1/0.1 | 94.4/0.3 |
| 4 | PMMA 3MDR | "PU/Si Blend" | | 2.6 | 80.0/0.1/20 86.0/0.3/60 96.3/0.4/85 | 78.9/0.4/20 83.7/1.1/60 89.8/0.6/85 | NA | NA |
| | | | | | | | NA | NA |
| 6 | Solar Glass 3MDR | "PU/Si Blend" | | 2.6 | 83.3/0.2/20 88.9/0.2/60 97.3/0.4/85 | 82.0/1.0/20 86.6/1.4/60 87.2/2.0/85 | NA | NA |
| 7 | GM2 3MDR | "PU/Si Blend" | | 2.6 | NA | NA | 81/0.01 | 80.2/0.4 |
| | | | | | | | | 80.2/0.5 |
| 9 | GM1 3MDR | (9:1)(7:3) "NALCO 8699":"SN OWTEX UP": "NEO REZ R960 | 5 | 2 | NA | NA | 88.3/0.5 | 88.0/0.4 |
| 10 | GM1 3MDR | (9:1) "NALCO 1115": "NEOREZ R-960" (5% "POLYST EP A-18") | 2.5 | 2 | NA | NA | 88.8/0.2 | 88.0/0.2 |
| 11 | GM1 3MDR | (8:2) "NALCO 1115":"NE OREZ R960" (5% "POLYST EP A-18") | 2.5 | 2 | NA | NA | 88.4/0.4 | 87.7/0.5 |
| 12 | "SMF1100" 3MDR | (9:1)(7:3) "NALCO 8699":"SN OWTEX UP": "NEO REZ R960 | 5 | 2 | NA | NA | 95.6/0.2 | 93.1/0.2 |
| 13 | "SMF1100" 3MDR | (9:1) "NALCO 1115":"NE OREZ R960" (5% "POLYST EP A-18") | 2.5 | 2 | NA | NA | 95.9/0.07 | 43.5/7.8 |
| 14 | "SMF1100" 3MDR | (8:2) "NALCO 1115":"NE OREZ R960" (5% "POLYST EP A-18") | 2.5 | 2 | NA | NA | 95.8/0.09 | 92.6/0.9 |

| | | | | | | | | |
|---|---|---|---|---|---|---|---|---|
| NOTES: "NA"= not applicable; "NC" = no coating; 3MDR=see "3 minute dwell rinse"; 1MDR=see "1 min dwell rinse; | | | | | | | | |

**Table 2**

| Example | Substrate | Composition | Solution conc wt% | pH | Post coat heat treat °C | Wavelength Averaged Reflection %T |
|---|---|---|---|---|---|---|
| NC | "SMF1100" | N/A | N/A | N/A | N/A | 87 |
| NC | cool mirror | N/A | N/A | N/A | NA | 87 |
| NC | broadband mirror | N/A | N/A | N/A | N/A | 84 |
| | cool mirror | 9:1 "NALCO 2327": "NEOCRYL A612" | 5 | 1.5 | NONE | 94 |
| | cool mirror | 63:27:10 "NALCO 1115": "SNOWTEX OUP: "NEOREZ R960" | 5 | 2.5 | NONE | 94 |
| | cool mirror | 40:40:20 "NALCO 1115": "SNOWTEX OUP": "NEOREZ R960" | 5 | 2.5 | NONE | 94 |
| | cool mirror | 63:27:10:1 "NALCO 8699": "1% POLYSTEP A-18": "SNOWTEX OUP": "NEOREZ R960" | 5 | 2.5 | NONE | 94 |
| | cool mirror | 63:27:10 "NALCO 8699": "SNOWTEX OUP": "NEOREZ R960" | 5 | 2.5 | NONE | 94 |
| | Broadband mirror | 63:27:10 "NALCO 8699": "SNOWTEX OUP": NEOREZ R960" | 5 | 2.5 | NONE | 93 |

| | | | | | | |
|---|---|---|---|---|---|---|
| NOTES: "NA"= not applicable; "NC" = no coating; All coatings done with #6 Meyer bar; For wavelengths averaged over in "Wavelength Averaged Reflection" for specific substrates see ""Wavelength Averaged Reflection Measurement". | | | | | | |

Various modifications and alterations of this disclosure may be made by those skilled in the art without departing from the scope of this disclosure, and it should be understood that this disclosure is not to be unduly limited to the illustrative embodiments set forth herein.

## Claims

1. A method of providing a coating to a surface of an optical element of a solar energy conversion system comprising:
a) coating the surface of the optical element with an aqueous coating composition having a pH of 5 or less and comprising water and silica nanoparticles dispersed in the water; and
b) heating the optical element to at least 300 °C to dry the coating composition to form a nanoparticle coating,
wherein the silica nanoparticles comprise a polymer core surrounded by a shell comprising nonporous silica particles disposed on the polymer core.

2. The method of claim 1 wherein the nonporous silica particles are spherical and have a volume average particle diameter of 60 nanometers or less.

3. The method of claim 1 or 2 wherein the coating is rinsed prior to drying.

4. The method of claims 1 to 3 wherein the optical element is placed into the solar energy conversion system after the optical element is coated with the coating composition.

5. The method of claim 1, wherein the optical element is heated to at least 400 °C.

6. The method of claim 1, wherein the optical element is heated to at least 500 °C.

7. The method of claim 1, wherein the optical element is heated to at least 600 °C.

8. The method of claim 1, wherein the optical element is heated to at least 700 °C.

## Patentansprüche

1. Ein Verfahren zum Bereitstellen einer Beschichtung auf einer Oberfläche eines optischen Elements eines Solarenergie-Umwandlungssystems, umfassend:
a) Beschichten der Oberfläche des optischen Elements mit einer wässrigen Beschichtungszusammensetzung, die einen pH-Wert von 5 oder weniger aufweist und Wasser und in dem Wasser dispergierte Siliciumdioxid-Nanoteilchen umfasst; und
b) Erwärmen des optischen Elements auf mindestens 300 °C, um die Beschichtungszusammensetzung zu trocknen um eine Nanoteilchen-Beschichtung zu bilden,
wobei die Siliciumdioxid-Nanoteilchen einen Polymerkern umfassen, der von einer Hülle umgeben ist, die nicht-poröse Siliciumdioxidteilchen umfasst, die auf dem Polymerkern angeordnet sind.

2. Das Verfahren nach Anspruch 1, wobei die nicht-porösen Siliciumdioxidteilchen kugelförmig sind und einen volumenmittleren Teilchendurchmesser von 60 Nanometern oder weniger aufweisen.

3. Das Verfahren nach Anspruch 1 oder 2, wobei die Beschichtung vor dem Trocknen gespült wird.

4. Das Verfahren nach den Ansprüchen 1 bis 3, wobei das optische Element in das Solarenergie-Umwandlungssystem eingebracht wird, nachdem das optische Element mit der Beschichtungszusammensetzung beschichtet wurde.

5. Das Verfahren nach Anspruch 1, wobei das optische Element auf mindestens 400 °C erwärmt wird.

6. Das Verfahren nach Anspruch 1, wobei das optische Element auf mindestens 500 °C erwärmt wird.

7. Das Verfahren nach Anspruch 1, wobei das optische Element auf mindestens 600 °C erwärmt wird.

8. Das Verfahren nach Anspruch 1, wobei das optische Element auf mindestens 700 °C erwärmt wird.

## Revendications

1. Procédé de fourniture d'un revêtement à une surface d'un élément optique d'un système de conversion d'énergie solaire comprenant :
a) le revêtement de la surface de l'élément optique avec une composition aqueuse de revêtement ayant un pH de 5 ou moins et comprenant de l'eau et des nanoparticules de silice dispersées dans l'eau ; et
b) le chauffage de l'élément optique à au moins 300 °C pour sécher la composition de revêtement pour former un revêtement de nanoparticules,
dans lequel les nanoparticules de silice comprennent un noyau polymère entouré par une enveloppe comprenant des particules de silice non poreuses disposées sur le noyau polymère.

2. Procédé selon la revendication 1 dans lequel les particules de silice non poreuses sont sphériques et ont un diamètre particulaire moyen en volume de 60 nanomètres ou moins.

3. Procédé selon la revendication 1 ou 2 dans lequel le revêtement est rincé avant séchage.

4. Procédé selon les revendications 1 à 3 dans lequel l'élément optique est placé dans le système de conversion d'énergie solaire après que l'élément optique est revêtu avec la composition de revêtement.

5. Procédé selon la revendication 1, dans lequel l'élément optique est chauffé à au moins 400 °C.

6. Procédé selon la revendication 1, dans lequel l'élément optique est chauffé à au moins 500 °C.

7. Procédé selon la revendication 1, dans lequel l'élément optique est chauffé à au moins 600 °C.

8. Procédé selon la revendication 1, dans lequel l'élément optique est chauffé à au moins 700 °C.
